# EUROPÄISCHE PATENTSCHRIFT

(11) **EP 3 036 431 B1**
(45) Veröffentlichungstag und Bekanntmachung des Hinweises auf die Patenterteilung: **18.11.2020**
(21) Anmeldenummer: 15729426.5
(22) Anmeldetag: 11.06.2015
(51) Int. Cl.: H01L 41/083, H01L 41/23, F02M 63/00, H01L 41/053

(54) **PIEZOAKTOR FÜR EINEN KRAFTSTOFFINJEKTOR UND KRAFTSTOFFINJEKTOR**
PIEZO ACTUATOR FOR A FUEL INJECTOR, AND FUEL INJECTOR
ACTIONNEUR PIÉZO-ÉLECTRIQUE POUR INJECTEUR DE CARBURANT ET INJECTEUR DE CARBURANT

(30) Priorität: 04.08.2014 DE 102014215327
(43) Veröffentlichungstag der Anmeldung: 29.06.2016
(73) Patentinhaber: Vitesco Technologies GmbH, 30165 Hannover (DE)
(72) Erfinder: SCHÜRZ, Willibald, 93188 Pielenhofen (DE); REIM, Werner, 93059 Regensburg (DE)
(74) Vertreter: Waldmann, Georg Alexander
(86) Internationale Anmeldenummer: PCT/EP2015/063021
(87) Internationale Veröffentlichungsnummer: WO 2016/020090

(56) Entgegenhaltungen:
- DE-A1- 19 914 411
- DE-A1-102005 046 174
- DE-A1-102012 212 264
- US-A1- 2003 107 301

## Beschreibung

Die Erfindung betrifft einen Piezoaktor für einen Kraftstoffinjektor sowie einen Kraftstoffinjektor, der diesen Piezoaktor aufweist.

Kraftstoffinjektoren mit Piezoaktoren werden beispielsweise in Brennkraftmaschinen zum Zumessen von Kraftstoff in einen Brennraum eingesetzt. Im Hinblick auf hohe Anforderungen an Brennkraftmaschinen, die in Kraftfahrzeugen angeordnet sind, wie beispielsweise hinsichtlich einer sehr gezielten Leistungseinstellung beziehungsweise der Erfüllung strenger Schadstoff-Emissionsvorschriften, ist ein präzises Zumessen des Kraftstoffes mittels eines Kraftstoffinjektors wichtig.

Für solche Kraftstoffinjektoren kommen zur Kraftstoffeinspritzung neben Solenoid-Antrieben auch Piezoaktoren zur Anwendung. Diese werden insbesondere bei Diesel-Brennkraftmaschinen eingesetzt, denn der zuzumessende Kraftstoff wird im Falle von Diesel häufig mit einem sehr hohen Druck von etwa 2000 bar bis 2500 bar dem Kraftstoffinjektor zugeführt und dann mittels des Kraftstoffinjektors in den jeweiligen Brennraum der Brennkraftmaschine zugemessen.

Piezoaktoren, die in Kraftstoffinjektoren verwendet werden, werden zur Verbesserung ihres Wirkungsgrades mit einer vom Querschnitt eines in dem Piezoaktor angeordneten Piezoschichtstapels abhängigen Kraft vorgespannt. Durch die Vorspannung wird auch eine ausreichende Dauerlauffähigkeit erzielt. Weiter ist es vorteilhaft, wenn der Piezoaktor vor Kontakt mit Kraftstoff geschützt wird, da der Kraftstoff Isolierungen des Piezoaktors und elektrische Kontaktierungen beschädigen könnte.

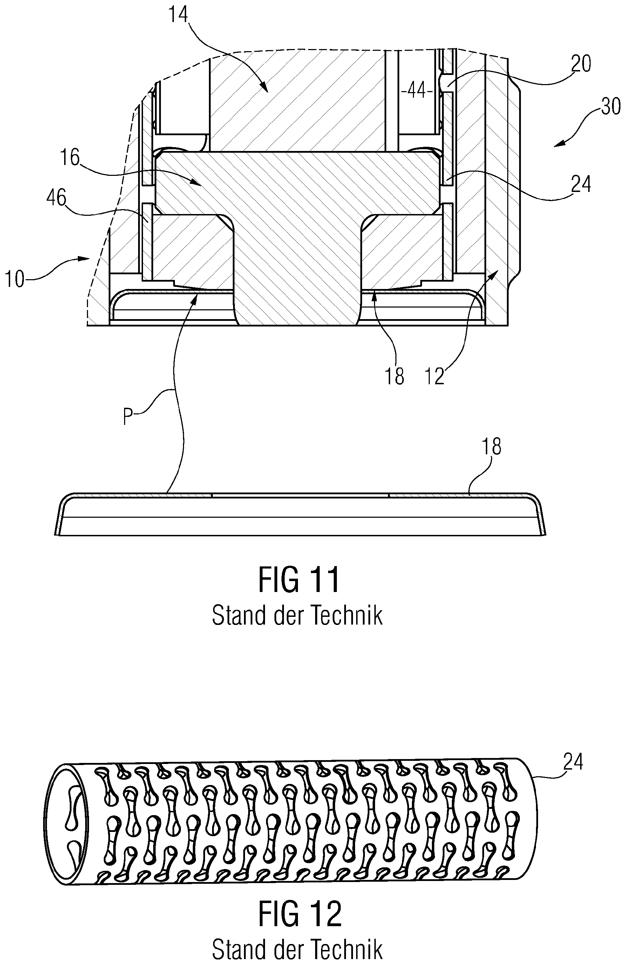

Fig. 11 und Fig. 12 zeigen eine bekannte Lösung zur Vorspannung und Abdichtung eines Piezoaktors.

In Fig. 11 ist ein Teilbereich aus einem Kraftstoffinjektor 10 gezeigt, wobei in einem Injektorkörper 12 ein Piezoschichtstapel 14 angeordnet ist, der mit einer Bodenplatte 16 abgeschlossen ist. Zur Abdichtung ist eine in der unteren Darstellung in Fig. 11 einzeln gezeigte Membran 18 vorgesehen, die, wie durch den Pfeil P dargestellt ist, derart an den Injektorkörper 12 angeschweißt ist, das eine Bohrung 20, in der der Piezoschichtstapel 14 angeordnet ist, gegen eine Umgebung 22 abgedichtet ist.

Die Bodenplatte 16 und der Piezoschichtstapel 14 sind von einer Rohrfeder 24, dargestellt in Fig. 12, umgeben, die fest mit der Bodenplatte 16 und gegenüberliegend zu der Bodenplatte 16 mit einer nicht gezeigten Kopfplatte 26 verbunden ist.

In der bekannten Kraftstoffinjektor-Anordnung gemäß Fig. 11 und Fig. 12 werden die beiden Funktionen Vorspannen und Abdichten demgemäß mit zwei getrennten Bauteilen realisiert. Die Vorspannung erfolgt mittels der Rohrfeder 24, während die Abdichtung mit der Membran 18 erfolgt, welche am Injektorkörper 12 und an der Bodenplatte 16 angeschweißt ist.

Bei großen Aktorhüben, wie sie beispielsweise bei Kraftstoffinjektoren mit einer direkt angetriebenen Düsennadel notwendig sind, wird jedoch die Belastbarkeitsgrenze dieser Membranen überschritten. Insbesondere tritt bei Kraftstoffinjektoren mit einem hydraulischen Spielausgleich auch eine Belastung wegen thermischer Längenänderungsunterschiede zwischen einem Piezoaktor und dem Injektorkörper als quasi-statischer Hub auf.

Weiter werden in der Zukunft Einspritzsysteme gefordert, die bis zu zehn Einspritzungen pro Arbeitsspiel durchführen. Dadurch entstehen hohe elektrische Verluste, die die Temperaturen im Piezoaktor ansteigen lassen. Es ist jedoch wichtig, die Temperatur an der Oberfläche des Piezoschichtstapels und in dem Piezoaktor unterhalb einer maximal zulässigen Temperatur zu halten.

Aufgabe der Erfindung ist es daher, einen verbesserten Piezoaktor vorzuschlagen, der die oben genannten Anforderungen erfüllt.

Die Druckschrift DE 10 2012 212 264 A1 offenbart einen Festkörperaktuator mit einer Aktuatorbaueinheit, einer Kopfplatte und einer Bodenplatte, wobei die Kopfplatte und die Bodenplatte derart an einem Wellrohr fixiert sind, das die Aktuatorbaueinheit mit einer vorgegebenen Vorspannung zwischen der Kopfplatte und der Bodenplatte eingespannt ist.

In dem Dokument DE 199 14 411 A1 ist ein piezoelektrischer Aktor gezeigt, der in einem Ventilgehäuse verbaut ist. Der Aktor umfasst einen piezoelektrischen Schichtstapel, der von einer Elastomerhülle umhüllt ist, die im eingebauten Zustand eng an der Innenwand einer Axialbohrung des Ventilgehäuses im Bereich des piezoelektrischen Schichtstapels anliegt.

Diese Aufgabe wird mit einem Piezoaktor mit den Merkmalen des Anspruches 1 gelöst.

Ein Kraftstoffinjektor, der einen solchen Piezoaktor aufweist, ist Gegenstand des nebengeordneten Anspruches.

Vorteilhafte Ausgestaltungen der Erfindung sind Gegenstand der abhängigen Ansprüche.

Ein Piezoaktor für einen Kraftstoffinjektor weist einen Piezoschichtstapel mit einer Längserstreckung, eine den Piezoschichtstapel umgebende Isolationsschicht mit einer von dem Piezoschichtstapel abgewandten Isolationsschichtaußenoberfläche, die einen Außendurchmesser der Isolationsschicht definiert, sowie eine Vorspanneinrichtung zum Vorspannen des Piezoschichtstapels entlang der Längserstreckung auf, wobei die Vorspanneinrichtung eine zu dem Piezoschichtstapel zugewandte Vorspanneinrichtungsinnenoberfläche aufweist, die einen Innendurchmesser der Vorspanneinrichtung definiert. Der Außendurchmesser der Isolationsschicht ist in einem nicht zusammengebauten Zustand größer als der Innendurchmesser der Vorspanneinrichtung, so dass in einem zusammengebauten Zustand die Isolationsschicht in der Vorspanneinrichtung verpresst ist. Die Vorspanneinrichtung ist ferner vorgesehen, in einem Injektorkörper des Kraftstoffinjektors mit einem Zwischenraum zwischen Injektorkörper und Vorspanneinrichtung angeordnet zu werden.

Durch diese Anordnung kommen die Vorspanneinrichtung und die Isolationsschicht in engen Kontakt zueinander, so dass während des Betriebes des Piezoaktors entstehende Arbeitswärme über den Kontakt von Isolationsschicht und Vorspanneinrichtung an eine Umgebung abgeführt werden kann. Dadurch, dass der Außendurchmesser der Isolationsschicht größer ist als der Innendurchmesser der Vorspanneinrichtung kommt es beim Einfügen des Piezoschichtstapels zu einer definierten Verpressung der Isolationsschicht und somit zu einem festgelegten Verhältnis zwischen der Vorspanneinrichtungsinnenoberfläche und der Isolationsschichtaußenoberfläche, was zu einem definierten Wärmestrom führt.

Zusätzlich hat eine solche definierte Verpressung der Isolationsschicht in der Vorspanneinrichtung den Vorteil, dass der Piezoschichtstapel automatisch in der Vorspanneinrichtung zentriert wird.

Vorzugsweise weist die Vorspanneinrichtung einen ersten Endbereich und einen zweiten Endbereich sowie einen Erstreckungsbereich zwischen dem ersten und zweiten Endbereich auf, wobei der Innendurchmesser der Vorspanneinrichtung wenigstens in einem der beiden Endbereiche größer ist als in dem Erstreckungsbereich. Insbesondere ist der Innendurchmesser der Vorspanneinrichtung in dem Endbereich größer als in dem Erstreckungsbereich, der bei der Herstellung des Piezoaktors die Seite bildet, von welcher her der Piezoschichtstapel in die Vorspanneinrichtung eingeführt wird. So wird vorteilhaft ein Abschaben der Isolationsschicht während des Zusammenfügens von Vorspanneinrichtung und Piezoschichtstapel mit Isolationsschicht vermieden.

Aus diesem Grund ist es besonders vorteilhaft, wenn die Vorspanneinrichtung wenigstens an dem Endbereich mit dem größeren Innendurchmesser abgerundete Kanten aufweist. Besonders bevorzugt jedoch weist die Vorspanneinrichtung in allen Bereichen, die beim Fügen mit der Isolationsschicht in Kontakt kommen, abgerundete Kanten auf.

Zum Abdichten des Piezoaktors gegen eine Umgebung ist es von Vorteil, wenn die Vorspanneinrichtung fest mit den anderen Elementen des Piezoaktors verbunden ist. Dazu weist der Piezoschichtstapel an einem ersten Ende vorteilhaft eine ihn abschließende Kopfplatte und an einem zweiten Ende eine ihn abschließende Bodenplatte auf, wobei die Vorspanneinrichtung vorzugsweise an Kopfplatte und Bodenplatte zum Abdichten des Piezoschichtstapels und der Isolationsschicht gegen die Umgebung angeschweißt ist.

In besonders vorteilhafter Ausgestaltung ist an der Isolationsschichtaußenoberfläche eine dreidimensionale Oberflächenstruktur angeordnet. Durch die dreidimensionale Oberflächenstruktur kann vorteilhaft besonders einfach eine Ausformung der Isolationsschicht erreicht werden, so dass die Isolationsschicht einen größeren Außendurchmesser aufweist als der Innendurchmesser der Vorspanneinrichtung. Das Fügen von Piezoschichtstapeln mit Isolationsschicht und Vorspanneinrichtung wird vorzugsweise deutlich vereinfacht, wenn nicht die gesamte Isolationsschichtaußenoberfläche einen größeren Außendurchmesser aufweist als der Innendurchmesser der Vorspanneinrichtung, sondern vorteilhaft nur vorbestimmte Bereiche der dreidimensionalen Oberflächenstruktur. Denn wäre die Isolationsschicht in ihrem Außendurchmesser insgesamt größer als der Innendurchmesser der Vorspanneinrichtung, ergäbe sich eine sehr hohe Fügekraft, die zunächst überwunden werden muss, um den Piezoschichtstapel mit die ihn umgebende Isolationsschicht in die Vorspanneinrichtung einzufügen.

Beispielsweise kann die dreidimensionale Oberflächenstruktur durch eine Verrippung an der Isolationsschicht realisiert werden. Vorteilhafte Beispiele für eine Verrippung sind Längsrippen, die besonders bevorzugt gleichmäßig am Umfang der Isolationsschicht verteilt angeordnet sind. Beispielsweise können drei Längsrippen oder vier Längsrippen vorgesehen sein.

Alternativ oder zusätzlich kann jedoch auch eine oder mehrere um die Oberfläche der Isolationsschicht umlaufende Schraubenrippe vorgesehen sein. Alternativ oder zusätzlich ist es auch denkbar, eine im Querschnitt senkrecht zur Längserstreckung als Vieleck ausgebildete Isolationsschicht vorzusehen. Beispiele sind hier eine sechseckige, achteckige, fünfeckige oder sternförmige Querschnittsform.

Um das Fügen von Piezoschichtstapeln mit umgebender Isolationsschicht und Vorspanneinrichtung besonders vorteilhaft auszugestalten, ist die dreidimensionale Oberflächenstruktur im Querschnitt senkrecht zur Längserstreckung vorzugsweise verjüngend ausgebildet. Das bedeutet, sie verjüngt sich vorteilhaft von dem Piezoschichtstapel weg zu der Vorspanneinrichtung hin.

Vorzugsweise weist das Material der Isolationsschicht einen größeren Wärmeausdehnungskoeffizienten auf als das Material der Vorspanneinrichtung. Besonders vorteilhaft ist die Vorspanneinrichtung aus Stahl gebildet. Im Betrieb dehnt sich somit die Isolationsschicht vorzugsweise stärker aus als die Vorspanneinrichtung, was vorteilhaft zu einer vergrößerten Kontaktfläche zwischen Isolationsschichtaußenoberfläche und Vorspanneinrichtungsinnenoberfläche führt, wodurch ein vorteilhafter verbesserter Wärmetransport möglich ist.

Beispielsweise ist die Isolationsschicht mit einem Elastomer, zum Beispiel mit Silikon, gebildet.

Vorzugsweise ist die Isolationsschicht mit einem thermisch leitfähigen und elektrisch isolierenden Material gebildet. Dazu sind beispielsweise in ein elektrisch isolierendes Elastomer thermisch leitfähige Partikel eingebettet.

Es ist beispielhaft auch möglich, eine Isolationsschicht aus einem elektrisch nicht leitfähigen Material auszubilden und darauf eine dreidimensionale Oberflächenstruktur anzubringen, die thermisch leitfähig ist, beispielsweise indem sie mit thermisch leitfähigen Partikel versetzt ist. In diesem Fall beugt die elektrisch nicht leitfähige Isolationsschicht vorteilhaft einem elektrischen Überschlag durch einen unerwünschten Kontakt der Partikel mit Innenelektroden des Piezoschichtstapels vor. Die elektrisch nicht leitfähige Isolationsschicht hat dabei vorzugsweise eine deutlich geringere Schichtdicke als die dreidimensionale Oberflächenstruktur, um einen Wärmestau zu vermeiden.

Vorteilhaft ist die Differenz von Außendurchmesser der Isolationsschicht zu Innendurchmesser der Vorspanneinrichtung so gewählt, dass eine Verpressungskraft zwischen Isolationsschicht und Vorspanneinrichtung in einem Bereich von 1 N bis 25 N, insbesondere 3 N bis 20 N, mehr insbesondere 5 N bis 10 N, liegt. In diesem Kräftebereich ist das Fügen von Piezoschichtstapel mit umgebender Isolationsschicht und Vorspanneinrichtung vorzugsweise möglich, ohne das es zu einer zu großen Kraftentwicklung kommt, was zu einer Beschädigung einzelner oder mehrerer Elemente des Piezoaktors führen könnte.

Vorzugsweise beträgt eine Überdeckungsfläche der Vorspanneinrichtungsinnenoberfläche durch die dreidimensionale Oberflächenstruktur maximal 50%, bevorzugt 15% bis 35%, der Vorspanneinrichtungsinnenoberfläche. Diese Bereiche sind insbesondere während des Herstellungsprozesses des Piezoaktors bei Raumtemperatur bevorzugt. Denn kommt es im Betrieb des Piezoaktors zu einer Erwärmung und damit zu einer Ausdehnung der Materialien, erhöht sich der Füllgrad und damit die Überdeckungsfläche. Um vorteilhaft die Beschädigung des Piezoaktors zu vermeiden, wird daher die Überdeckungsfläche bei der Herstellung so gewählt, dass eine Überfüllung im Betrieb vorteilhaft vermieden wird.

In einer besonders bevorzugten Ausgestaltung ist die Vorspanneinrichtung durch eine Wellenfeder mit einem in Richtung der Längserstreckung wellenförmigen Verlauf gebildet. Dabei ist die Wellenfeder insbesondere eine den Piezostapel und die Isolationsschicht umgebende rohrförmige Wellenfeder. Die Herstellung einer solchen Wellenfeder ist beispielsweise in DE 10 2012 212 264 A1 beschrieben, deren Offenbarung hier mit einbezogen ist. Eine rohrförmige Wellenfeder ermöglicht vorteilhaft eine besonders gute Abdichtung, wenn sie an der Bodenplatte und an der Kopfplatte angeschweißt ist, gegen die Umgebung und gleichzeitig eine gute Vorspannung des Piezostapels entlang seiner Längserstreckung.

Die Wellenfeder weist dabei wenigstens einen zu dem Piezoschichtstapel zugewandten ersten Wellenberg und wenigstens einen von dem Piezoschichtstapel abgewandten zweiten Wellenberg auf, wobei der Innendurchmesser der Wellenfeder als Vorspanneinrichtung durch den ersten Wellenberg definiert wird.

Ein Kraftstoffinjektor weist eine Injektornadel und einen die Injektornadel antreibenden Piezoaktor auf. Dabei ist der Piezoaktor wie oben beschrieben ausgebildet.

Vorzugsweise wird die Injektornadel dabei direkt von dem Piezoaktor angetrieben, das heißt ohne eine hydraulische Servoanordnung dazwischen.

In dem Kraftstoffinjektor ist vorzugsweise zwischen einem Injektorkörper und der Vorspanneinrichtung des Piezoaktors ein Raum vorgesehen, in den im Betrieb vorteilhaft Kraftstoff geführt wird. Der Kraftstoff wird dabei besonders bevorzugt in einem Niederdruckbereich geführt. Dadurch ist es möglich, Luftspalte, beispielsweise bauartbedingt zwischen dem Injektorkörper und dem Piezoaktor liegend, mit einem Material, nämlich Kraftstoff zu füllen, und somit eine vorteilhafte thermische Anbindung zu realisieren, die ebenfalls zur Ableitung von Arbeitswärme des Piezoaktors beiträgt.

Der Piezoaktor wird derart hergestellt, dass zunächst der Piezoschichtstapel mit einer dünnen Passivierungsschicht von etwa 2 µm bis etwa 10 µm Schichtdicke bedeckt wird. Diese Passivierungsschicht kann beispielsweise als Haftvermittler wirken und ist zum Beispiel aus Silikon gebildet. Danach wird der so passivierte Piezoschichtstapel in ein Spritzgusswerkzeug, vorzugsweise ein zweiteiliges Spritzgusswerkzeug, eingelegt, das so ausgebildet ist, dass es die dreidimensionale Oberflächenstruktur vorgibt. Das Spritzgusswerkzeug wird geschlossen und beispielsweise mit Silikon oder den bereits oben beschriebenen Isolationsschichtmaterialen ausgespritzt. Durch die spezielle Formgebung des Spritzgusswerkzeuges ergibt sich eine dreidimensionale Oberflächenstruktur an der Isolationsschichtaußenoberfläche, beispielsweise eine Verrippung wie oben beschrieben oder eine im Querschnitt senkrecht zur Längserstreckung ausgebildete Vieleck-Form der Isolationsschicht.

Vorteilhafte Ausgestaltungen der Erfindung werden nachfolgend anhand der beigefügten Zeichnungen näher erläutert. Dabei zeigt:
- Fig. 1: einen Kraftstoffinjektor mit einer von einem Piezoaktor angetriebenen Injektornadel;
- Fig. 2: eine perspektivische Ansicht von einem ersten Endbereich des Piezoaktors aus Fig. 1, der einen Piezoschichtstapel und eine Isolationsschicht sowie eine umgebende Vorspanneinrichtung aufweist;
- Fig.3: den Piezoschichtstapel mit Isolationsschicht aus Fig.2 in einer ersten Ausführungsform;
- Fig. 4: den Piezoschichtstapel mit Isolationsschicht aus Fig. 2 in einer zweiten Ausführungsform;
- Fig. 5: den Piezoschichtstapel mit Isolationsschicht aus Fig. 2 in einer dritten Ausführungsform;
- Fig. 6: eine schematische Ansicht auf einen Querschnitt durch die Isolationsschicht senkrecht zu der Längserstreckung des Piezoaktors aus Fig. 1 mit einer sechseckigen Querschnittsform;
- Fig. 7: eine schematische Ansicht auf einen Querschnitt durch die Isolationsschicht senkrecht zu der Längserstreckung des Piezoaktors aus Fig. 1 mit einer achteckigen Querschnittsform;
- Fig. 8: eine schematische Ansicht auf einen Querschnitt durch die Isolationsschicht senkrecht zu der Längserstreckung des Piezoaktors aus Fig. 1 mit einer fünfeckigen Querschnittsform;
- Fig. 9: eine schematische Ansicht auf einen Querschnitt durch die Isolationsschicht senkrecht zu der Längserstreckung des Piezoaktors aus Fig. 1 mit einer sternförmigen Querschnittsform;
- Fig. 10: eine Ansicht von vorne auf den Piezoaktor aus Fig. 1, wobei im rechten Bereich die Vorspanneinrichtung entfernt ist;
- Fig. 11: einen Teilbereich eines Kraftstoffinjektors gemäß dem Stand der Technik; und
- Fig. 12: eine Rohrfeder zum Vorspannen eines Piezoaktors gemäß dem Stand der Technik.

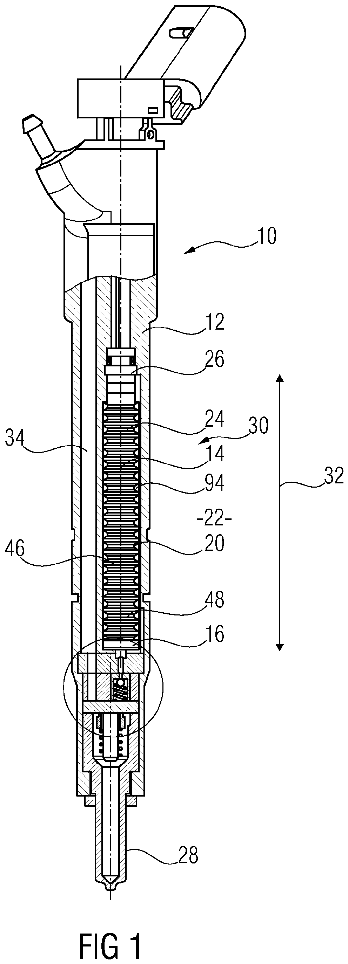

Fig. 1 zeigt einen Kraftstoffinjektor 10 mit einer Injektornadel 28, die durch einen Piezoaktor 30 angetrieben wird. Der Piezoaktor 30 ist in einem Injektorkörper 12 des Kraftstoffinjektors 10 untergebracht und erstreckt sich mit einer Längserstreckung 32 durch den Injektorkörper 12. Parallel zu dem Piezoaktor 30 ist eine Bohrung 34 in dem Injektorkörper 12 angeordnet, durch die Kraftstoff 36 zur Injektornadel 28 geführt wird, um bei Öffnung der Injektornadel 28 in einen nicht dargestellten Brennraum einer Brennkraftmaschine eingespritzt zu werden.

Der Piezoaktor 30 weist im Inneren einen Piezoschichtstapel 14 auf, bei dem eine Vielzahl an piezoelektrisch aktiven Schichten abwechselnd mit Innenelektrodenschichten übereinander gestapelt sind. Wird der Piezoschichtstapel 14 über die Innenelektrodenschichten mit einer Spannung beaufschlagt, verändert sich die Ausdehnung der piezoelektrischen Schichten, was zu einer Längenänderung des Piezoaktors 30 entlang seiner Längserstreckung 32 führt. Dadurch entsteht ein Hub, der entweder hydraulisch oder direkt auf die Injektornadel 28 übertragen wird und diese öffnet, so dass der über die Bohrung 34 zugeführte Kraftstoff 36 in den Brennraum einer Brennkraftmaschine eingespritzt werden kann.

Durch die Längenänderung des Piezoaktors 30 entsteht Arbeitswärme an dem Piezoaktor 30, die von dem Piezoaktor 30 abgeführt werden muss. Bei derzeit auf dem Markt befindlichen Kraftstoffinjektoren 10, wie sie beispielweise bei der Diesel Common Rail-Technik verwendet werden, ist die Wärmeabfuhr vom Piezoschichtstapel 14 an den Injektorkörper 12, dass heißt das Aktorgehäuse, ohne besondere Maßnahmen lösbar, da die Anzahl der Einspritzungen pro Arbeitsspiel relativ gering ist und sich im Bereich von drei Einspritzungen pro Arbeitsspiel bewegt. Bei zukünftigen Einspritzsystemen werden jedoch bis zu zehn Einspritzungen pro Arbeitsspiel realisiert. Proportional dazu steigen auch die elektrischen Verluste und im gleichen Ausmaß die Temperaturen im Piezoaktor 30 an. Um die Temperatur an der Oberfläche des Piezoschichtstapels 14 unterhalb einer maximal zulässigen Temperatur von beispielsweise 170°C zu halten, sind daher Maßnahmen erforderlich, welche den Wärmestrom in Richtung Injektorkörper 12 vergrößern.

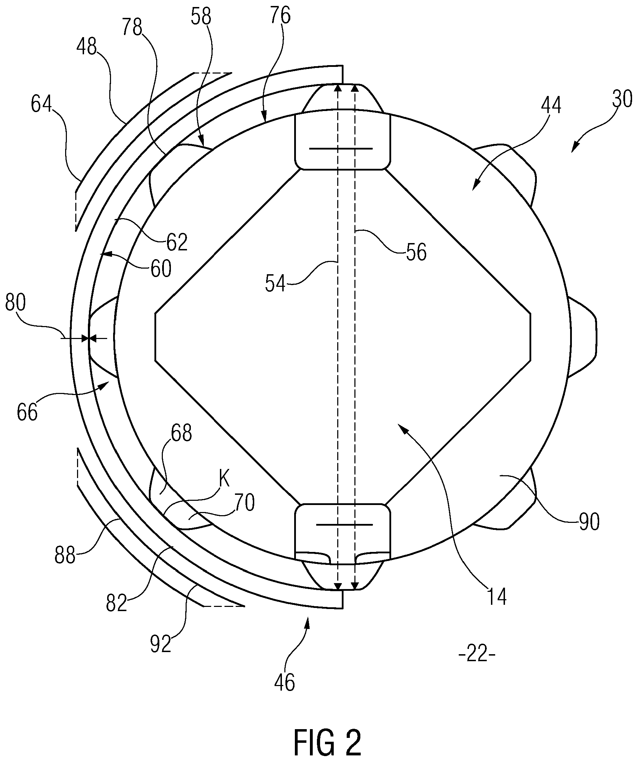

Daher wird nun eine Lösung wie in Fig. 2 dargestellt vorgeschlagen.

Fig. 2 zeigt eine perspektivische Ansicht schräg auf eine Stirnseite des Piezoaktors 30 aus Fig. 1. Um den Piezoschichtstapel 14 herum ist eine Isolationsschicht 44 angeordnet, welche wiederum von einer Vorspanneinrichtung 46 umgeben ist. Die Vorspanneinrichtung 46 ist, wie in Fig. 1 gezeigt, als Wellenfeder 48 ausgebildet und umgibt den Piezoschichtstapel 14 mit die ihn umgebende Isolationsschicht 44 rohrförmig. Wie ebenfalls in Fig. 1 zu sehen ist, ist die Wellenfeder 48 an einer Kopfplatte 26 und einer Bodenplatte 16, die den Piezoschichtstapel 14 nach oben und nach unten abschließen, fest angeschweißt. Dadurch wird über die Wellenfeder 48 eine zuverlässige Vorspannung und gleichzeitige Abdichtung - zusammen mit Bodenplatte 16 und Kopfplatte 26 - gegen eine Umgebung 22 realisiert. Die Wellenfeder 48 erfüllt somit zwei Funktionen, nämlich das Vorspannen und das Abdichten und ist daher besonders geeignet, bei einem beschränkten Bauraum verwendet zu werden. Dadurch kann der in Fig. 2 dargestellte Piezoaktor 30 auch einfach in einem Inline-Injektorkonzept verwendet werden, in dem der Piezoaktor 30 in den Injektorkörper 12 integriert ist, wie dies beispielsweise in Fig. 1 dargestellt ist. Der zur Verfügung stehende Bauraum ist in dieser Anordnung stark eingeschränkt.

Zusätzlich wird in der Anordnung gemäß Fig. 2 ein hoher Wärmestrom in Richtung des Injektorkörpers 12 realisiert, da ein Außendurchmesser 54 der Isolationsschicht 44, wie in Fig. 2 zu sehen ist, größer ist als ein Innendurchmesser 56 der Vorspanneinrichtung 46.

Der Außendurchmesser 54 der Isolationsschicht 44 wird dabei definiert durch eine von dem Piezoschichtstapel 14 abgewandte Isolationsschichtaußenoberfläche 58, und der Innendurchmesser 56 der Vorspanneinrichtung 46 wird definiert durch eine zu dem Piezoschichtstapel 14 zugewandte Vorspanneinrichtungsinnenoberfläche 60.

Wird die Vorspanneinrichtung 46 durch eine Wellenfeder 48 gebildet, weist die Wellenfeder 48 mehrere zu dem Piezoschichtstapel 14 zugewandte erste Wellenberge 62 sowie mehrere von dem Piezoschichtstapel 14 abgewandte zweite Wellenberge 64 auf. In diesem Fall wird der Innendurchmesser 56 der Wellenfeder 48 durch die Vorspanneinrichtungsinnenoberfläche 60 im Bereich der ersten Wellenberge 62 definiert.

Durch die in Fig. 2 gezeigte Anordnung wird eine bauraumoptimale Vorspannungs- und Abdichtungslösung realisiert, welche einen möglichst hohen Wärmestrom in Richtung des Injektorkörpers 12 gewährleistet. Denn einerseits wird eine Kombination der Vorspann- und Abdichtfunktion mittels der Wellenfeder 48 realisiert und andererseits ein maximaler Wärmestrom durch Optimierung eines Kontaktbereiches K zwischen der Isolationsschicht 44 und der Vorspanneinrichtungsinnenoberfläche 60, das heißt der Wellrohrinnenseite, erzielt.

Um ein Einfügen des von der Isolationsschicht 44 umgebenden Piezoschichtstapels 14 in die Wellenfeder 48 zu erleichtern, weist die Isolationsschicht 44 nicht insgesamt einen größeren Außendurchmesser 54 auf als der Innendurchmesser 56 der Wellenfeder 48, sondern hat an ihrer Isolationsschichtaußenoberfläche 58 eine dreidimensionale Oberflächenstruktur 66.

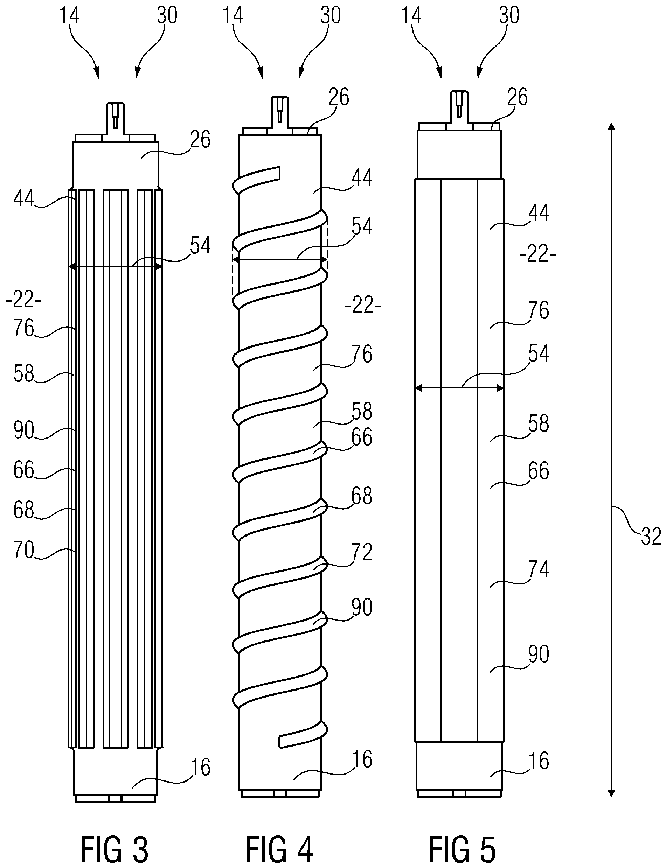

Diese dreidimensionale Oberflächenstruktur 66 kann beispielsweise durch eine Verrippung 68 gebildet sein, wie sie zum Beispiel in Fig. 2 im Querschnitt und in Fig. 3 und Fig. 4 in einer Ansicht von vorne gezeigt ist. Dabei können mehrere Längsrippen 70, aber beispielsweise auch eine oder mehrere Schraubenrippen 72 an der Isolationsschicht 44 angeordnet sein. Auch eine Kombination der genannten dreidimensionalen Oberflächenstrukturen 66 ist möglich.

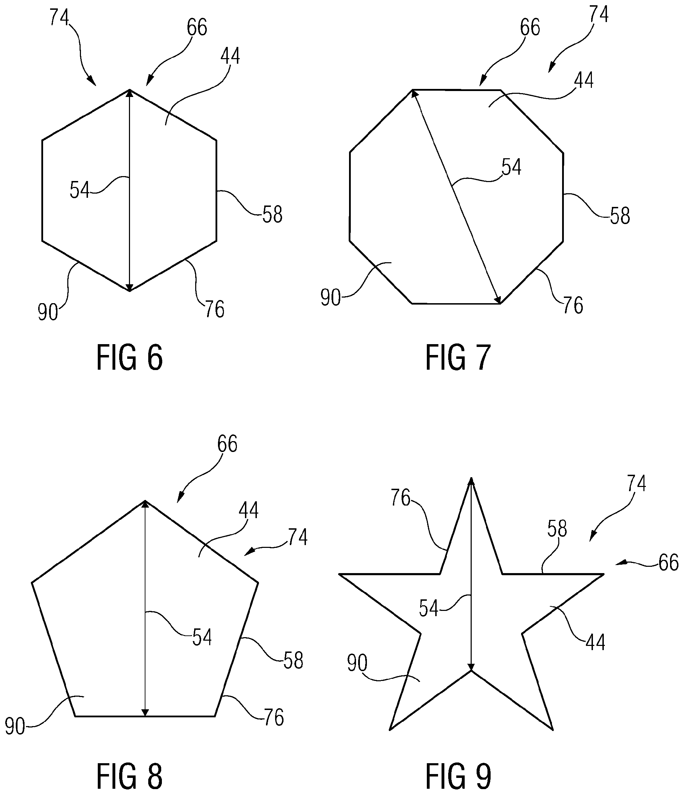

Alternativ oder zusätzlich kann die Isolationsschicht 44 im Querschnitt senkrecht zur Längserstreckung 32 des Piezoaktors 30 aber auch als Vieleck 74 ausgebildet sein. Dies ist in einer Draufsicht in Fig. 5 gezeigt. Beispiele für eine vieleckige Querschnittform der Isolationsschicht 44 sind in Fig. 6 bis Fig. 9 gezeigt. Fig. 6 zeigt dabei eine sechseckige Querschnittsform, Fig. 7 eine achteckige Querschnittsform, Fig. 8 eine fünfeckige Querschnittsform und Fig. 9 eine sternförmige Querschnittsform.

Die Erzielung eines maximalen Wärmestromes wird daher durch die Ausformung der Isolationsschicht 44 an den Piezoschichtstapel 14 in der Form erreicht, dass die Isolationsschicht 44 beispielsweise an ihrer Oberfläche 76, das heißt ihrem Umfang, eine Verrippung 68 aufweist, deren Außendurchmesser 54 größer ist als der Innendurchmesser 56 der Wellenfeder 48. Dadurch kommt es beim Einfügen des Piezoschichtstapels 14 in die Wellenfeder 48 zu einer definierten Verpressung der Isolationsschicht 44 und somit zu einem festgelegten Verhältnis zwischen der Wellenfederinnenoberfläche 60 und der Kontaktfläche zur Isolationsschicht 44.

Wie in Fig. 2 weiter zu sehen ist, verjüngt sich die dreidimensionale Oberflächenstruktur 66 im Querschnitt senkrecht zur Längserstreckung 32 von dem Piezoschichtstapel 14 weg zu der Vorspanneinrichtung 46 hin. Dadurch wird das Fügen von Piezoschichtstapel 14 mit Isolationsschicht 44 und Vorspanneinrichtung 46 erleichtert.

Die dreidimensionale Oberflächenstruktur 66 ist so vorgesehen, dass eine Überdeckungsfläche 78 der Vorspanneinrichtungsinnenoberfläche 60 durch die dreidimensionale Oberflächenstruktur 66 maximal 50% beträgt. Ein vorteilhafter Bereich liegt zwischen 15% bis 35% der Vorspanneinrichtungsinnenoberfläche 60.

Die Differenz des Außendurchmessers 54 zu dem Innendurchmesser 56 ist so gewählt, dass eine Verpressungskraft 80 zwischen Isolationsschicht 44 und Vorspanneinrichtung 46 in einem Bereich von 1 N bis 25 N, insbesondere in einem Bereich von 3 N bis 20 N liegt. Besonders vorteilhaft ist dabei ein Bereich von 5 N bis 10 N.

Durch die definierten Werte der Überdeckungsfläche 78 und der Verpressungskraft 80 ist einerseits das Fügen von Piezoschichtstapel 14 und Isolationsschicht 44 mit der Vorspanneinrichtung 46 erleichtert, andererseits wird bei einer erhöhten Betriebstemperatur des Piezoaktors 30 eine Beschädigung der einzelnen Elemente des Piezoaktors 30 durch eine zu große Krafteinwirkung von der Isolationsschicht 44 auf die Vorspanneinrichtung 46 verhindert.

Um das Fügen von Piezoschichtstapel 14 und Isolationsschicht in die Vorspanneinrichtung 46 weiter zu erleichtern, ist es vorteilhaft, wenn die Vorspanneinrichtung an einem ersten Endbereich 82 und/oder an einem zweiten Endbereich 84 einen größeren Innendurchmesser 56 aufweist als in einem Erstreckungsbereich 86, der zwischen den Endbereichen 82, 84 liegt. Das heißt, wenn die Wellenfeder 48 auf der Seite, von welcher der Piezoschichtstapel 14 eingeführt wird, einen vergrößerten Innendurchmesser 56 aufweist, kann ein Abschaben der Isolationsschicht 44 während des Fügens verhindert werden.

Im Fall der Wellenfeder 48 entsteht auch keine Beschädigung der Isolationsschicht 44 durch die Wellenberge 62, 64, da diese keine scharfen Kanten besitzen, wie das beispielsweise bei den gestanzten Rohrfedern 24 aus dem Stand der Technik bekannt ist. Daher ist es auch vorteilhaft, wenn zumindest in einem der Endbereiche 82, 84 nur abgerundete Kanten 88 vorhanden sind.

In Fig. 3 bis Fig. 9 sind vorteilhafte Ausführungsformen der Isolationsschicht 44 gezeigt, nämlich die genannten Längsrippen 70, eine oder mehrere Schraubenrippen 72 oder eine Vieleckquerschnittsfläche 74. Durch die Wahl der Umspritzgeometrie kann auch die Höhe der Verpressungskraft beeinflusst werden.

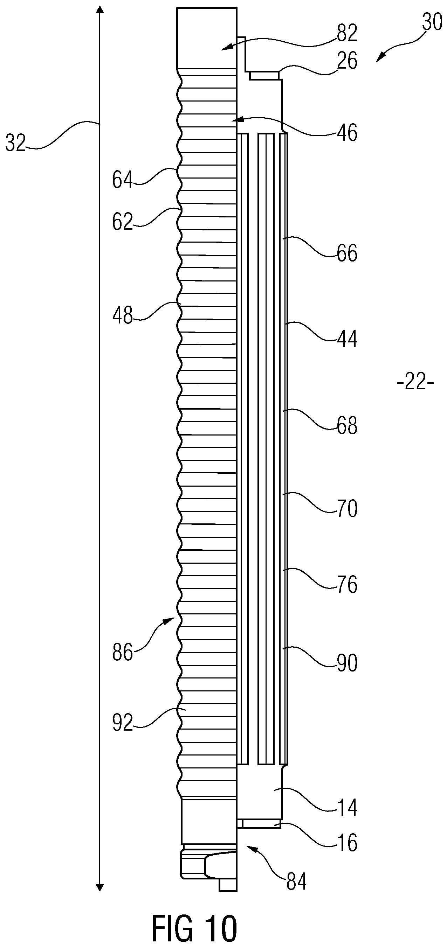

Fig. 10 zeigt eine Darstellung des Piezoaktors 30, bei dem im rechten Bereich die Wellenfeder 48 entfernt dargestellt ist, um so den Blick auf die Isolationsschicht 44 mit der dreidimensionalen Oberflächenstruktur 66 freizugeben.

Ein zusätzlicher Vorteil der Verpressung der Isolationsschicht 44 in der Wellenfeder 48 ist die automatische Zentrierung des Piezoschichtstapels 14 in der Wellenfeder 48.

Bei der Auslegung der Verpressungskraft 80 ist darauf zu achten, dass diese bei Raumtemperatur einen Maximalwert nicht überschreitet, da durch die höhere Wärmeausdehnung, die gewöhnlich das Material der Isolationsschicht 44 hat, beispielsweise wenn es aus Silikon 90 gebildet ist, im Vergleich zu der zumeist aus Stahl 92 gebildeten Wellenfeder 48 mit steigender Temperatur zu einer Überfüllung des Innenraumes der Wellenfeder 48 kommen könnte. Die Zunahme der Verpressungskraft mit steigender Temperatur ist andererseits jedoch wünschenswert, da damit der maximal mögliche Wärmetransport steigt. Der Anstiegsgradient der Temperatur des Piezoschichtstapels 14 wird dadurch mit steigender Temperatur verringert.

Um eine thermische Ankopplung des Piezoaktors 30 zum Injektorkörper 12 noch weiter zu verbessern, weist der in Fig. 1 gezeigte Kraftstoffinjektor 10 einen Raum 94 zwischen Wellenfeder 48 und Injektorkörper 12 auf, der im Betrieb mit Kraftstoff 36 im Niederdruckbereich gefüllt ist. Das verwendete Material der Isolationsschicht 44, in der Regel ein Silikonelastomer, weist eine geringe Wärmeleitfähigkeit auf, und zwischen der Oberfläche des isolierten Piezoschichtstapels 14 bis zum Injektorkörper 12 liegen je nach Design des Kraftstoffinjektors 10 noch mindestens zwei Luftspalte, so dass dies zu einer ungünstigen thermischen Anbindung führt. Beispielsweise bei Anwendung von Mehrfacheinspritzungsstrategien - auch bei hohen Drehzahlen und Lasten - führt dies zu einer unzulässig hohen Temperatur im Material der Isolationsschicht 44, da kein ausreichender Wärmestrom in Richtung des Injektorkörpers 12 erreicht werden kann. Ist jedoch der Raum 94 zwischen Wellenfeder 48 und Injektorkörper 12 mit Kraftstoff 36 gefüllt, treten Luftspalte, welche den Wärmetransport im Betrieb sehr nachteilig beeinflussen können, nicht auf.

Insgesamt beruht die Anordnung auf der Kombination der Abdicht- und Vorspannfunktion einer als Wellenfeder 48 ausgeformten Rohrfeder 24, in welche der Piezoschichtstapel 14 eingesetzt ist, dessen Isolationsschicht 44 eine definierte Verpressungskraft 80 zur Wellenfeder 48 besitzt. Damit wird der Wärmestrom von der Oberfläche des Piezoschichtstapels 14 zur Wellenfeder 48 vergrößert, wodurch auch bei hoher Anzahl von Einspritzungen pro Arbeitszyklus unzulässig hohe Temperaturen in der Isolationsschicht 44 und dem Piezoschichtstapel 14 verhindert werden können. Gleichzeitig wird eine gute Zentrierung des Piezoschichtstapels 14 in der Wellenfeder 48 realisiert.

### Bezugszeichen

- 10: Kraftstoffinjektor
- 12: Injektorkörper
- 14: Piezoschichtstapel
- 16: Bodenplatte
- 18: Membran
- 20: Bohrung (Piezoschichtsstapel)
- 22: Umgebung
- 24: Rohrfeder
- 26: Kopfplatte
- 28: Injektornadel
- 30: Piezoaktor
- 32: Längserstreckung
- 34: Bohrung (Kraftstoff)
- 36: Kraftstoff
- 44: Isolationsschicht
- 46: Vorspanneinrichtung
- 48: Wellenfeder
- 54: Außendurchmesser
- 56: Innendurchmesser
- 58: Isolationsschichtaußenoberfläche
- 60: Vorspanneinrichtungsinnenoberfläche
- 62: erster Wellenberg
- 64: zweiter Wellenberg
- 66: dreidimensionale Oberflächenstruktur
- 68: Verrippung
- 70: Längsrippe
- 72: Schraubenrippe
- 74: Vieleck
- 76: Oberfläche
- 78: Überdeckungsfläche
- 80: Verpressungskraft
- 82: erster Endbereich
- 84: zweiter Endbereich
- 86: Erstreckungsbereich
- 88: abgerundete Kante
- 90: Silikon
- 92: Stahl
- 94: Raum
- P: Pfeil
- K: Kontaktbereich

## Patentansprüche

1. Piezoaktor (30) für einen Kraftstoffinjektor (10), aufweisend
- einen Piezoschichtstapel (14) mit einer Längserstreckung (32),
- eine den Piezoschichtstapel (14) umgebende Isolationsschicht (44) mit einer von dem Piezoschichtstapel (14) abgewandten Isolationsschichtaußenoberfläche (58), die einen Außendurchmesser (54) der Isolationsschicht (44) definiert,
- eine Vorspanneinrichtung (46) zum Vorspannen des Piezoschichtstapels (14) entlang der Längserstreckung (32),
wobei die Vorspanneinrichtung (46) eine zu dem Piezoschichtstapel (14) zugewandte Vorspanneinrichtungsinnenoberfläche (60) aufweist, die einen Innendurchmesser (56) der Vorspanneinrichtung (46) definiert, wobei der maximale Außendurchmesser (54) der Isolationsschicht (44) in einem nicht zusammengebauten Zustand größer ist als der minimale Innendurchmesser (56) der Vorspanneinrichtung (46), so dass in einem zusammengebauten Zustand die Isolationsschicht (44) in der Vorspanneinrichtung (46) verpresst ist,
**dadurch gekennzeichnet,**
**dass** die Vorspanneinrichtung (46) vorgesehen ist, in einem Injektorkörper (12) des Kraftstoffinjektors (10) mit einem Zwischenraum (94) zwischen Injektorkörper (12) und Vorspanneinrichtung (46) angeordnet zu werden.

2. Piezoaktor (30) nach Anspruch 1,
**dadurch gekennzeichnet, dass** die Vorspanneinrichtung (46) einen ersten Endbereich (82) und einen zweiten Endbereich (84) sowie einen Erstreckungsbereich (86) zwischen dem ersten und zweiten Endbereich (82, 84) aufweist, wobei der Innendurchmesser (56) der Vorspanneinrichtung (46) wenigstens in einem der beiden Endbereiche (82, 84) größer ist als in dem Erstreckungsbereich (86).

3. Piezoaktor (30) nach Anspruch 2,
**dadurch gekennzeichnet, dass** die Vorspanneinrichtung (46) wenigstens an dem Endbereich (82, 84) mit dem größeren Innendurchmesser (56) abgerundete Kanten (88) aufweist.

4. Piezoaktor (30) nach einem der Ansprüche 1 bis 3,
**dadurch gekennzeichnet, dass** an der Isolationsschichtaußenoberfläche (58) eine dreidimensionale Oberflächenstruktur (66) angeordnet ist.

5. Piezoaktor (30) nach Anspruch 4,
**dadurch gekennzeichnet, dass** die dreidimensionale Oberflächenstruktur (66) durch eine Verrippung (68), insbesondere durch Längsrippen (70) und/oder durch wenigstens eine um eine Oberfläche (76) der Isolationsschicht (44) umlaufende Schraubenrippe (72), und/oder durch eine im Querschnitt senkrecht zur Längserstreckung (32) als Vieleck (74) ausgebildete Isolationsschicht (44) gebildet ist.

6. Piezoaktor (30) nach einem Ansprüche 4 oder 5,
**dadurch gekennzeichnet, dass** die dreidimensionale Oberflächenstruktur (66) im Querschnitt senkrecht zur Längserstreckung (32) sich von dem Piezoschichtstapel (14) weg zu der Vorspanneinrichtung (46) hin verjüngend ausgebildet ist.

7. Piezoaktor (30) nach einem der Ansprüche 1 bis 6, **dadurch gekennzeichnet, dass** die Differenz von maximalem Außendurchmesser (54) der Isolationsschicht (44) zu minimalem Innendurchmesser (56) der Vorspanneinrichtung (46) so gewählt ist, dass eine Verpressungskraft (80) zwischen Isolationsschicht (44) und Vorspanneinrichtung (46) in einem Bereich von 1 N bis 25 N, insbesondere 3 N bis 20 N, mehr insbesondere 5 N bis 10 N, liegt.

8. Piezoaktor (30) nach einem der Ansprüche 4 bis 7, **dadurch gekennzeichnet, dass** eine Überdeckungsfläche (78) der Vorspanneinrichtungsinnenoberfläche (60) durch die dreidimensionale Oberflächenstruktur (66) maximal 50 %, insbesondere 15 % bis 35 %, der Vorspanneinrichtungsinnenoberfläche (60) beträgt.

9. Piezoaktor (30) nach einem der Ansprüche 1 bis 8, **dadurch gekennzeichnet, dass** die Vorspanneinrichtung (46) durch eine Wellenfeder (48) mit einem in Richtung der Längserstreckung (32) wellenförmigen Verlauf gebildet ist, wobei die Wellenfeder (48) insbesondere eine den Piezoschichtstapel (14) und die Isolationsschicht (44) umgebende rohrförmige Wellenfeder (48) ist.

10. Kraftstoffinjektor (10) mit einer Injektornadel (28) und einen die Injektornadel (28) antreibenden Piezoaktor (30), wobei der Piezoaktor (30) nach einem der Ansprüche 1 bis 9 ausgebildet ist.

## Claims

1. Piezo actuator (30) for a fuel injector (10), comprising
- a piezo layer stack (14) having a longitudinal extension (32),
- an insulation layer (44) surrounding the piezo layer stack (14) and having an insulation layer outer surface (58) which faces away from the piezo layer stack (14) and defines an outer diameter (54) of the insulation layer (44),
- a preloading device (46) for preloading the piezo layer stack (14) along the longitudinal extension (32),
wherein the preloading device (46) has a preloading device inner surface (60) which faces the piezo layer stack (14) and defines an inner diameter (56) of the preloading device (46), wherein, in a non-assembled state, the maximum outer diameter (54) of the insulation layer (44) is greater than the minimum inner diameter (56) of the preloading device (46), and therefore, in an assembled state, the insulation layer (44) is compressed in the preloading device (46), **characterized in that** the preloading device (46) is provided to be arranged in an injector body (12) of the fuel injector (10), with an intermediate space (94) between injector body (12) and preloading device (46).

2. Piezo actuator (30) according to Claim 1, **characterized in that** the preloading device (46) has a first end region (82) and a second end region (84) and also an extension region (86) between the first and second end region (82, 84), wherein the inner diameter (56) of the preloading device (46) is greater at least in one of the two end regions (82, 84) than in the extension region (86).

3. Piezo actuator (30) according to Claim 2, **characterized in that** the preloading device (46) has rounded edges (88) at least on the end region (82, 84) having the greater inner diameter (56).

4. Piezo actuator (30) according to one of Claims 1 to 3, **characterized in that** a three-dimensional surface structure (66) is arranged on the insulation layer outer surface (58) .

5. Piezo actuator (30) according to Claim 4, **characterized in that** the three-dimensional surface structure (66) is formed by a ribbed structure (68), in particular by longitudinal ribs (70) and/or by at least one helical rib (72) running around a surface (76) of the insulation layer (44), and/or by an insulation layer (44) formed as a polygon (74) in the cross section perpendicular to the longitudinal extension (32) .

6. Piezo actuator (30) according to either of Claims 4 and 5, **characterized in that** the three-dimensional surface structure (66) is formed tapering away from the piezo layer stack (14) toward the preloading device (46) in the cross section perpendicular to the longitudinal extension (32).

7. Piezo actuator (30) according to one of Claims 1 to 6, **characterized in that** the difference from maximum outer diameter (54) of the insulation layer (44) to minimum inner diameter (56) of the preloading device (46) is selected in such a manner that a compression force (80) between insulation layer (44) and preloading device (46) lies within a range of 1 N to 25 N, in particular 3 N to 20 N, more particularly 5 N to 10 N.

8. Piezo actuator (30) according to one of Claims 4 to 7, **characterized in that** a surface (78) of the preloading device inner surface (60) overlapped by the three-dimensional surface structure (66) is at maximum 50%, in particular 15% to 35%, of the preloading device inner surface (60).

9. Piezo actuator (30) according to one of Claims 1 to 8, **characterized in that** the preloading device (46) is formed by a zigzag spring (48) having a profile which is sinuous in the direction of the longitudinal extension (32), wherein the zigzag spring (48) is in particular a tubular zigzag spring (48) surrounding the piezo layer stack (14) and the insulation layer (44).

10. Fuel injector (10) comprising an injector needle (28) and a piezo actuator (30) driving the injector needle (28), wherein the piezo actuator (30) is formed according to one of Claims 1 to 9.

## Revendications

1. Actionneur piézo-électrique (30) pour un injecteur de carburant (10), présentant
- un empilement de couches piézo-électriques (14) ayant une extension longitudinale (32),
- une couche d'isolation (44) entourant l'empilement de couches piézo-électriques (14), dotée d'une surface extérieure de couche d'isolation (58), détournée de l'empilement de couches piézo-électriques (14) et définissant le diamètre extérieur (54) de la couche d'isolation (44),
- un dispositif de précontrainte (46) pour exercer une précontrainte sur l'empilement de couches piézo-électriques (14) le long de l'extension longitudinale (32),
dans lequel le dispositif de précontrainte (46) présente une surface intérieure de dispositif de précontrainte (60) tournée vers l'empilement de couches piézo-électriques (14) et définissant un diamètre intérieur (56) du dispositif de précontrainte (46),
dans lequel, dans un état non assemblé, le diamètre extérieur maximal (54) de la couche d'isolation (44) est supérieur au diamètre intérieur minimal (56) du dispositif de précontrainte (46) de sorte que dans un état assemblé, la couche d'isolation (44) est pressée dans le dispositif de précontrainte (46), **caractérisé en ce que** le dispositif de précontrainte (46) est prévu pour être disposé dans un corps d'injecteur (12) de l'injecteur de carburant (10) avec un intervalle (94) entre le corps d'injecteur (12) et le dispositif de précontrainte (46).

2. Actionneur piézo-électrique (30) selon la revendication 1, **caractérisé en ce que** le dispositif de précontrainte (46) présente une première zone d'extrémité (82) et une deuxième zone d'extrémité (84) ainsi qu'une zone d'extension (86) entre la première et la deuxième zone d'extrémité (82, 84), le diamètre intérieur (56) du dispositif de précontrainte (46) étant supérieur à celui dans la zone d'extension (86), au moins dans l'une des deux zones d'extrémité (82, 84).

3. Actionneur piézo-électrique (30) selon la revendication 2, **caractérisé en ce que** le dispositif de précontrainte (46) présente des bords (88) arrondis au moins au niveau de la zone d'extrémité (82, 84) ayant le diamètre intérieur supérieur (56) .

4. Actionneur piézo-électrique (30) selon l'une quelconque des revendications 1 à 3, **caractérisé en ce qu'**une structure de surface tridimensionnelle (66) est disposée au niveau de la surface extérieure de couche d'isolation (58).

5. Actionneur piézo-électrique (30) selon la revendication 4, **caractérisé en ce que** la structure de surface tridimensionnelle (66) est formée par un nervurage (68), en particulier par des nervures longitudinales (70) et/ou par au moins une nervure hélicoïdale (72) périphérique autour d'une surface (76) de la couche d'isolation (44), et/ou par une couche d'isolation (44) réalisée en forme de polygone (74) en section transversale, perpendiculairement à l'extension longitudinale (32).

6. Actionneur piézo-électrique (30) selon l'une quelconque des revendications 4 et 5, **caractérisé en ce que** la structure de surface tridimensionnelle (66) est réalisée en section transversale, perpendiculairement à l'extension longitudinale (32), en s'amincissant en partant de l'empilement de couches piézo-électriques (14) jusqu'au dispositif de précontrainte (46) .

7. Actionneur piézo-électrique (30) selon l'une quelconque des revendications 1 à 6, **caractérisé en ce que** la différence entre le diamètre extérieur maximal (54) de la couche d'isolation (44) et le diamètre intérieur minimal (56) du dispositif de précontrainte (46) est sélectionnée de telle sorte qu'une force de pressage (80) entre la couche d'isolation (44) et le dispositif de précontrainte (46) est comprise dans une plage de 1 N à 25 N, en particulier de 3 N à 20 N, plus particulièrement de 5 N à 10 N.

8. Actionneur piézo-électrique (30) selon l'une quelconque des revendications 4 à 7, **caractérisé en ce qu'**une surface de recouvrement (78) de la surface intérieure de dispositif de précontrainte (60) à travers la structure de surface tridimensionnelle (66) est au maximum 50 %, en particulier de 15 % à 35 %, de la surface intérieure de dispositif de précontrainte (60).

9. Actionneur piézo-électrique (30) selon l'une quelconque des revendications 1 à 8, **caractérisé en ce que** le dispositif de précontrainte (46) est formé par un ressort ondulé (48) ayant une allure ondulée en direction de l'extension longitudinale (32), le ressort ondulé (48) étant en particulier un ressort ondulé (48) tubulaire entourant l'empilement de couches piézo-électriques (14) et la couche d'isolation (44).

10. Injecteur de carburant (10) comprenant une aiguille d'injecteur (28) et un actionneur piézo-électrique (30) entraînant l'aiguille d'injecteur (28), l'actionneur piézo-électrique étant réalisé selon l'une quelconque des revendications 1 à 9.
